# EUROPEAN PATENT APPLICATION

(11) **EP 4 462 151 A1**
(43) Date of publication of application: **13.11.2024**
(21) Application number: 23305745.4
(22) Date of filing: 11.05.2023
(51) Int. Cl.: G01S 7/40, H03G 3/30

(54) **RADAR TRANSMITTER OUTPUT POWER CALIBRATION VIA A STANDING WAVE SIGNAL DETECTOR AND A CALIBRATION APPARATUS**

(71) Applicant: NXP B.V., 5656 AG Eindhoven (NL)
(72) Inventor: El Ozeir, Mohamad, 31023 Toulouse Cedex 1 (FR); Savary, Pierre Pascal, 31023 Toulouse Cedex 1 (FR); Pavao Moreira, Cristian, 31023 Toulouse Cedex 1 (FR); de Graauw, Antonius Johannes Matheus, 31023 Toulouse Cedex 1 (FR)
(74) Representative: Schmütz, Christian Klaus Johannes

(57) **Abstract**

A transmitter circuit includes a power amplifier and a mixer calibration circuit. The power amplifier provides a transmission signal. The mixer calibration circuit receives an incident signal of the transmission signal and a reflected signal of the transmission signal. Based on an amplitude of the reflected signal and on a phase difference between the incident and reflected signals, the mixer calibration circuit determines an amplitude of a standing wave signal. Based on the amplitude of the standing wave signal, the mixer calibration circuit causes a recalibration of an output voltage and the bias current of the power amplifier

## Description

### FIELD OF THE DISCLOSURE

This disclosure generally relates to the fabrication of semiconductor devices, and more particularly relates to radar transmitter output power calibration via a standing wave signal detector and a calibration apparatus.

### BACKGROUND

A radar transmitter includes multiple components including a power amplifier (PA), an antenna, and an antenna reference plane. In certain situations, an impedance mismatch may occur between the output of the PA and the antenna reference plane. In previous radar transmitters, radar transmitter output power calibration was utilized to compensate for a power loss due to this mismatch. Although the output power calibration may solve the mismatch issue, the calibration may cause the devices of the PA to enter an undesired operating area during particular conditions. For example, when the radar transmitter has very high output power and very high mismatch conditions, the devices of the PA may enter the undesired operating area. The undesired operating area may cause stress on components of the PA. In particular, the mismatch conditions may be corrected but a voltage swing at an output of the PA may exceed a safe operating area. The components of the PA may be damaged by the output voltage exceeding the safe operating area.

Radar transmitter may be improved by ensuring safe power control for the transmitter. However, this requires a breakthrough in the transmitter to find a new approach to ensure that the voltage standing wave signal will not exceed the safe operating area threshold once the mismatch is compensated.

### BRIEF DESCRIPTION OF THE DRAWINGS

It will be appreciated that for simplicity and clarity of illustration, elements illustrated in the Figures have not necessarily been drawn to scale. For example, the dimensions of some of the elements are exaggerated relative to other elements. Embodiments incorporating teachings of the present disclosure are shown and described with respect to the drawings presented herein, in which:
FIG. 1 illustrates a printed circuit board having a power amplifier and an antenna in accordance with an embodiment of the current disclosure;
FIG. 2 illustrates a block diagram of circuitry to perform output power calibration in accordance with an embodiment of the current disclosure;
FIG. 3 illustrates a block diagram of a mixer calibration circuitry in accordance with an embodiment of the current disclosure;
FIG. 4 illustrates a block diagram of a mixer gain trimmer circuitry in accordance with an embodiment of the current disclosure;
FIG. 5 illustrates a flow diagram of a method for recalibrating an output power of a power amplifier in accordance with an embodiment of the current disclosure;
FIG. 6 illustrates a block diagram of a mixer calibration circuitry in accordance with another embodiment of the current disclosure;
FIG. 7 illustrates a flow diagram of a method for recalibrating an output power of a power amplifier in accordance with another embodiment of the current disclosure;
FIG. 8 illustrates a block diagram of a mixer calibration circuitry in accordance with another embodiment of the current disclosure; and
FIG. 9 illustrates a flow diagram of a method for recalibrating an output power of a power amplifier in accordance with another embodiment of the current disclosure.

The use of the same reference symbols in different drawings indicates similar or identical items.

### SUMMARY OF THE INVENTION

A transmitter circuit includes a power amplifier and a mixer calibration circuit. The power amplifier may provide a transmission signal. The mixer calibration circuit may communicate with the power amplifier. The mixer calibration circuit may receive an incident signal of the transmission signal and a reflected signal of the transmission signal. Based on an amplitude of the reflected signal and on a phase difference between the incident and reflected signals, the mixer calibration circuit may determine an amplitude of a standing wave signal. Based on the amplitude of the standing wave signal, the mixer calibration circuit may cause recalibration of an output voltage and the bias current of the power amplifier.

### DETAILED DESCRIPTION OF DRAWINGS

The following description in combination with the Figures is provided to assist in understanding the teachings disclosed herein. The description will focus on specific implementations and embodiments of the teachings. This focus is provided to assist in describing the teachings, and should not be interpreted as a limitation on the scope or applicability of the teachings. Moreover, other teachings can be used in association with the teachings of this application, as needed or desired, without limiting the scope of the teachings herein.

In an embodiment of the current disclosure, a transmitter circuit may include a power amplifier and a mixer calibration circuit. The power amplifier may provide a transmission signal. The mixer calibration circuit may communicate with the power amplifier. The mixer calibration circuit may receive an incident signal of the transmission signal and a reflected signal of the transmission signal. Based on an amplitude of the reflected signal, a prior measurement/characterization of the mixer gain, and on a phase difference between the incident and reflected signals, the mixer calibration circuit may determine an amplitude of a standing wave signal. Based on the amplitude of the standing wave signal, the mixer calibration circuit may cause recalibration of an output voltage of the power amplifier.

In an embodiment, the transmitter circuit may also include a comparator coupled to the mixer calibration circuit. The comparator may compare the amplitude of the standing wave signal with a threshold value, and output a calibration mode signal. The transmitter may further include a control circuit coupled to the comparator. The control circuit may receive the calibration mode signal. In response to the calibration mode signal indicating a first calibration mode, the control circuit may increase a bias current to a driver of the power amplifier. In an embodiment, the increase of the bias current recalibrates the output voltage of the power amplifier. In response to the calibration mode signal indicating a second calibration mode, the control circuit may increase a supply voltage to the driver of the power amplifier. In an embodiment, the increase of the bias current recalibrates the output voltage of the power amplifier.

In an embodiment, the first calibration mode may be based on the amplitude of the standing wave signal being greater than the threshold value, and the second calibration mode is based on the amplitude of the standing wave signal being less than the threshold value. In response to the calibration mode signal indicating the second calibration mode, the control circuit may increase the bias current to the driver of the power amplifier.

In an embodiment, the mixer calibration circuit may include a phase control circuit and a mixer. The phase control circuit may receive the incident signal. Based on a first phase control signal, the phase control circuit may provide the incident signal with a zero degree phase shift. Based on a second phase control signal, the phase control circuit may provide the incident signal with a ninety degree phase shift. The mixer may be coupled to the phase control circuit. The mixer may receive the reflected signal, and receive the incident signal from the phase control circuit. Based on the incident signal having the zero degree phase shift, the mixer may provide a first output voltage. Based on the incident signal having the ninety degree phase shift, the mixer may provide a second output voltage, wherein the amplitude of the standing wave is calculated based on the first and second output voltages and on a phase difference between the incident and reflected signals.

In another embodiment, the mixer calibration circuit may include first and second phase control circuits, and first and second mixers. The first phase control circuit may receive the incident signal, and provide the incident signal with a zero degree phase shift. The second phase control circuit may receive the incident signal, and provide the incident signal with a ninety degree phase shift. The first mixer may be coupled to the first phase control circuit. The first mixer may receive the reflected signal, and receive the incident signal with the zero degree phase shift from the first phase control circuit. Based on the incident signal having the zero degree phase shift, the first mixer may provide a first output voltage. The second mixer may be coupled to the second phase control circuit. The second mixer may receive the reflected signal, and receive the incident signal with the ninety degree phase shift from the second phase control circuit. Based on the incident signal having the ninety degree phase shift, the second mixer may
provide a second output voltage. The amplitude of the standing wave may be calculated based on the first and second output voltages and on a phase difference between the incident and reflected signals.

In an embodiment, the transmitter circuit may further include a bi-directional coupler coupled to the power amplifier. The bi-directional coupler may provide the incident signal and the reflected signal to the mixer calibration circuit.

In another embodiment of the current disclosure, a method of re-calibrating a power amplifier is given. The method may include providing, by a power amplifier of a transmitter circuit, a transmission signal. The method may further include receiving, by a mixer calibration circuit of the transmitter circuit, an incident signal of the transmission signal and a reflected signal of the transmission signal. Based on an amplitude of the reflected signal and on a phase difference between the incident and reflected signals, the method may also include determining an amplitude of a standing wave signal. Based on the amplitude of the standing wave signal, the method may further include recalibrating an output voltage of the power amplifier.

In an embodiment, the method may further include comparing, by a comparator of the transmitter circuit, the amplitude of the standing wave signal with a threshold value. The method may also include outputting, by the comparator, a calibration mode signal.

In an embodiment, the method may further include receiving, by a control circuit of the transmitter circuit, the calibration mode signal. In response to the calibration mode signal indicating a first calibration mode, the method may also include increasing, by the control circuit, a bias current to a driver of the power amplifier. The increase of the bias current recalibrates the output voltage of the power amplifier. In response to the calibration mode signal indicating a second calibration mode, the method may further include increasing, by the control circuit, a supply voltage to the driver of the power amplifier. The increase of the bias current recalibrates the output voltage of the power amplifier.

In an embodiment, the first calibration mode is based on the amplitude of the standing wave signal being greater than the threshold value. The second calibration mode is based on the amplitude of the standing wave signal being less than the threshold value. In response to the
calibration mode signal indicating the second calibration mode, the control circuit may further increase the bias current to the driver of the power amplifier.

In an embodiment, the method may further include receiving, by a phase control circuit of the mixer calibration circuit, the incident signal. Based on a first phase control signal, the method may also include providing the incident signal with a zero degree phase shift. Based on a second phase control signal, the method may further include providing the incident signal with a ninety degree phase shift. The method may also include receiving, by a mixer of the mixer calibration circuit, the reflected signal, and receiving the incident signal from the phase control circuit. Based on the incident signal having the zero degree phase shift, the method may further include providing a first output voltage of the mixer. Based on the incident signal having the ninety degree phase shift, the method may also include providing a second output voltage of the mixer. The amplitude of the standing wave is calculated based on the first and second output voltages and on a phase difference between the incident and reflected signals.

In an embodiment, the method may further include receiving, by a first phase control circuit of the mixer calibration circuit, the incident signal. The method may also include providing, by the first phase control circuit, the incident signal with a zero degree phase shift. The method may further include receiving, by a second phase control circuit of the mixer calibration circuit, the incident signal. The method may also include providing, by the second phase control circuit, the incident signal with a ninety degree phase shift. The method may further include receiving, by a first mixer of the mixer calibration circuit, the reflected signal. The method may also include receiving, by the first mixer, the incident signal with the zero degree phase shift from the first phase control circuit. Based on the incident signal having the zero degree phase shift, the method may further include providing a first output voltage. The method may also include receiving, by a second mixer of the mixer calibration circuit, the reflected signal. The method may further include receiving, by the second mixer the incident signal with the ninety degree phase shift from the second phase control circuit. Based on the incident signal having the ninety degree phase shift, the method may also include providing a second output voltage. The amplitude of the standing wave is calculated based on the first and second output voltages and on a phase difference between the incident and reflected signals.

In yet another embodiment of the current disclosure, a transmitter circuit includes a power amplifier, a bi-directional coupler, a mixer calibration circuit, a comparator, and a control circuit. The power amplifier may provide a transmission signal. The bi-directional coupler may be coupled to the power amplifier, and provide an incident signal of the transmission signal and a reflected signal of the transmission signal. The mixer calibration circuit may be coupled to the
bi-directional coupler. The mixer calibration circuit may receive the incident signal and the reflected signal. Based on an amplitude of the reflected signal and on a phase difference between the incident and reflected signals, the mixer calibration circuit may determine an amplitude of a standing wave signal. Based on the amplitude of the standing wave signal, the mixer calibration circuit may cause recalibration of an output voltage of the power amplifier. The comparator may be coupled to the mixer calibration circuit. The comparator may compare the amplitude of the standing wave signal with a threshold value, and output a calibration mode signal. The control circuit may be coupled to the comparator. The control circuit may receive the calibration mode signal. In response to the calibration mode signal indicating a first calibration mode, the control circuit may increase a bias current to a driver of the power amplifier. The increase of the bias current recalibrates the output voltage of the power amplifier. In response to the calibration mode signal indicating a second calibration mode, the control circuit may increase a supply voltage to the driver of the power amplifier. The increase of the bias current recalibrates the output voltage of the power amplifier.

The first calibration mode may be based on the amplitude of the standing wave signal being greater than the threshold value. The second calibration mode may be based on the amplitude of the standing wave signal being less than the threshold value.

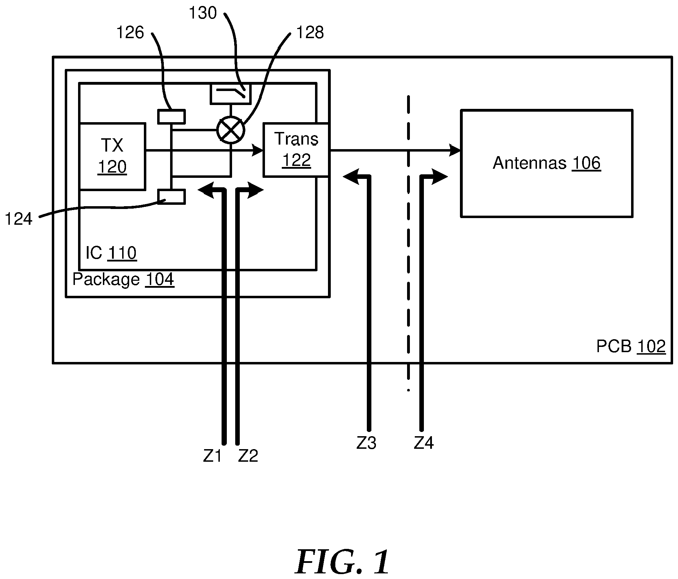

FIG. 1 illustrates a printed circuit board (PCB) 102 having package 104 and one or more antennas 106 in accordance with an embodiment of the current disclosure. Package 104 includes an integrated circuit (IC) 110. IC 110 includes a transmit power amplifier (PA) 120, a transmitter 122, detector circuits 124 and 126, a mixer 128, and a low pass filter 130. Detector circuits 124 and 126 may be any suitable type of voltage detector, such as a peak power detector (PPD) circuit. In an example, PCB 102 may include additional components without varying from the scope of this disclosure.

PCB 102 may include a PA output impedance Z 1, a transmitter impedance Z2, a transmitter output impedance Z3, and an antenna input impedance Z4 along a transmission path from PA 120 to antennas 106. When an ideal calibration condition exists within PCB 102, PA output impedance Z1 is matched to transmitter input impedance Z2, and transmitter output impedance Z3 is matched to antenna input impedance Z4. However, actual calibration conditions may be different such that transmitter input impedance Z2 and antenna input impedance Z4 vary compared to the respective initial calibration matched conditions. For example, actual conditions may cause the actual transmitter input impedance to equal Z2+deltaZ2 and the actual antenna input impedance to equal Z4+deltaZ4.

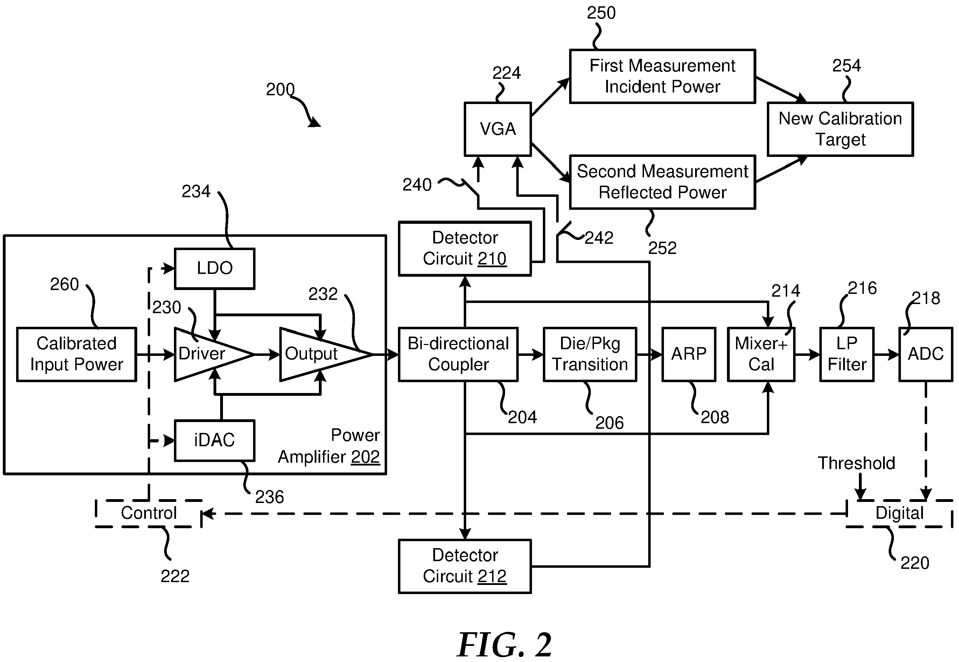

Detector circuits 124 and 126, mixer 128, and low pas filter 130 may combine to improve the calibration of the output from PA 120. Detector circuit 124 may detect a reflected signal from PA 120 and detector circuit 126 may detect an incident signal from PA 120. The detected signals may be provided from detector circuits 124 and 126 to mixer circuit 128. In response to receiving the detected signals, mixer circuit 128 may determine a phase difference between the reflected and incident output voltages. Based on the phase difference, LP 130 may be utilized to determine a voltage swing at the output of PA 120. The voltage swing and phase difference may be utilized during a recalibration as will be described with respect to FIGs. 2-9 below. The recalibration may prevent PA 120 from entering an undesired operating area that may cause stress on components of the PA. In particular, the recalibration as will be described with respect to FIGs. 2-9 below may correct the mismatch conditions and hold a voltage swing at an output of PA 120 within a safe operating area. Maintaining the voltage within the safe operating area may prevent the components of PA 120 from being damaged.

FIG. 2 illustrates circuitry 200 to perform output power calibration in accordance with an embodiment of the current disclosure. Circuitry 200 includes a PA 202, a bi-directional coupler 204, a die/package transition 206, an antenna reference plane (ARP) 208, and detector circuits 210 and 212. Circuitry 200 further includes a mixer circuit 214, a low pass (LP) filter 216, and analog-to-digital (ADC) converter 218, a digital comparator 220, a control circuit 222, and a voltage gain amplifier (VGA) 224. PA 202 includes a driver 230, an output 232, a load dropout (LDO) circuit 234, and a current digital-to-analog circuit (iDAC) 236. The functions and features of PA 202, bi-directional coupler 204, die/package transition 206, and ARP 208 are known in the art and will not be further disclosed herein, except as needed to illustrate the various embodiments disclosed herein. Circuitry 200 may include additional components without varying from the scope of this disclosure.

PA 202 may provide a signal to through bi-directional coupler 204 and die/package transition 206 to ARP 208. As the signal is provided through these components, a reflected signal may be sent back from ARP 208 toward PA 202. Bi-directional coupler 204 may separate the incident, or originally transmitted, signal from the reflected signal. Bi-directional coupler 204 may provide the incident signal to detector circuit 210, and provide the reflected signal to detector 212. In certain examples, detector circuit 210 may be a PPD circuit and may be coupled to the output of PA 202. Detector circuit 210 may detect or determine the amplitude of the output signal from PA 202. Detector circuit 212 may be a PPD circuit and may be isolated from the output of PA 202. Detector circuit 212 may detect or determine the amplitude of the reflected signal.

Detector circuits 210 and 212 may be coupled to VGA 224 through respective switches 240 and 242 in the communication paths between the detector circuits and the VGA. One of the switches 240 and 242 may be closed while the other switch is open, such that only one of the determined amplitudes is provided to VGA 224 at a time. For example, switch 240 may be closed and switch 242 may be open, such that VGA 224 may measure incident power 250. Next, switch 240 may be open and switch 242 may be closed, such that VGA may measure reflected power 252. Based on measure incident power 250 and measured reflected power 252, a new calibration target 254 may be calculated for PA 202. In an example, the calibration target 254 may be calculated based on a previous calibration target being added to the output voltage from detector circuit 212. The new calibration target 254 may be utilized as a calibrated input power 260 provided to driver 230 of PA 202.

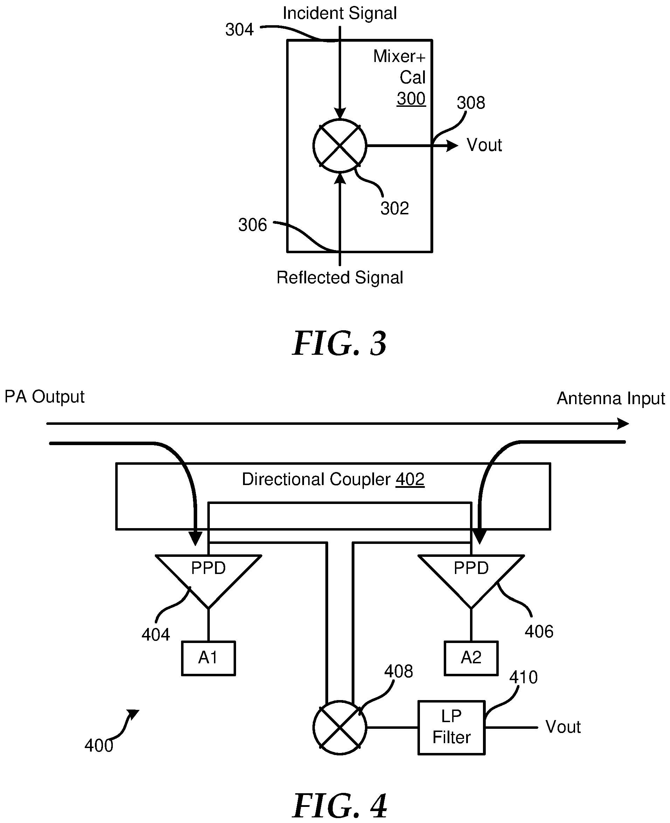

Bi-directional coupler 204 may provide the incident signal and the reflected signal to the mixer circuit 214. In response to receiving the incident and reflected signals, mixer circuit 214 may determine a phase difference between the two signals. Different embodiments of mixer circuit 214 will be described with respect to FIGs. 3-9 below. Based on the determined phase difference, mixer circuit 214 may determine a standing wave signal (SWS) amplitude at the output of PA 202. Based on the comparison, digital comparator 220 may provide a calibration mode signal to control circuit 222. For example, the calibration mode signal may indicate whether to increase voltage, increase current, or both of PA 202 to compensate for the impedance mismatch. In an example, the threshold value may be any suitable value, such as a safe operating area (SOA) value for PA 202. The comparison to a SOA threshold may ensure that the SOA threshold is not exceeded while still compensating for the power impedance mismatch.

Based on the calibration mode signal, control circuit 222 may determine whether to increase voltage, increase current, or both of PA 202 to compensate for the impedance mismatch. If control circuit 222 determines that the voltage should be increased, the control circuit may provide a control signal to LDO 234, which in turn may increase the supply voltage to driver 230 and output 232 of PA 202. If control circuit 222 determines that the current should be increased, the control circuit may provide a control signal to iDAC 236, which in turn may increase the bias current to driver 230 and output 232 of PA 202. Additionally, if control circuit 222 determines that both the voltage and the current should be increased, the control circuit may provide a control signal to both LDO 234 and iDAC 236. In response to the control signal, LDO 234 may increase the supply voltage to driver 230 and output 232 of PA 202 and iDAC 236 may increase the bias current to the driver and the output.

FIG. 3 illustrates mixer calibration circuitry 300 in accordance with an embodiment of the current disclosure. Mixer calibration circuitry 300 may be substantially similar to mixer circuit 214 of FIG. 2. Mixer calibration circuitry 300 includes a mixer 302, input terminals 304 and 306, and an output terminal 308. In an example, the incident signal, as described above with respect to FIG. 2, may be received at input terminal 304, and the reflected signal, as also described above with respect to FIG. 2, may be received at input terminal 306. In certain examples, input terminal 304 may be coupled to the LO input of mixer 302. Based on the incident signal being received at input terminal 304 and the LO input of mixer 302, the amplitude of the incident signal may be selected in a manner that does not affect a gain of the mixer. Mixer 302 may operate as a phase detector to determine a phase difference between the incident signal and the reflected signal.

The incident signal may be represented by V*rf*₁ = A₁^{∗}cos(wt + Φ₁), where A1 is the amplitude of the incident signal measured by detector circuit 210 of FIG. 2, and Φ₁ is the phase of the incident signal. The reflected signal received at input terminal 306 may be represented by V*rf*₂ = A₂^{∗}cos(wt + Φ₂), where A2 is the amplitude of the reflected signal measured by detector circuit 212 of FIG. 2, and Φ₂ is the phase of the reflected signal. Based on the incident signal and the reflected signal being received at mixer 302, the mixer may provide an output voltage signal at output terminal 308. In an example, the output voltage signal may be represented by V*ₒᵤₜ* = Aₘₐₓ^{∗}cos(Φ₂ - Φ₁ + Φ_{ofst}) + A_*ofst,* where Φ_ofst may be an offset amplitude and Φ_{ofst} may be an offset phase. In certain examples, both Φ_ofst and Φ_{ofst} may be values determined in a lab, and may represent correction values that may be independent on a process, voltage, and temperature (PVT) for the particular PCB.

Aₘₐₓ may be calculated based upon A₂ and a gain of mixer 302. The gain of mixer 302 may be determined or trimmed in any suitable manner. For example, the gain of mixer 302 may be trimmed by sweeping a gamma phase at the output of a transmitter, such as transmitter 122 of FIG. 1, to determine a correction factor. The sweeping of the gamma phase may generate a reflection coefficient of a matching ratio between the incident and reflected signals, and a Fast Fourier Transform (FFT) may be performed on the reflection coefficient to determine the correction factor. The correction factor may be loaded within digital circuit 220 during a start up sequence of the PCB.

Based on the equations above, Φ₂ - Φ₁ may be calculated, which is the phase of the reflected signal minus the phase of the incident signal. This difference may be referred to as the phase difference between the signals and this phase difference is utilized to correct an impedance mismatch as described above with respect to FIG. 2.

FIG. 4 illustrates mixer gain trimmer circuitry 400 in accordance with an embodiment of the current disclosure. Mixer gain trimmer circuitry 400 includes a bi-directional coupler 402, detector circuits 404 and 406, mixer circuitry 408, and a LP filter 410. Bi-directional coupler 402 may be substantially similar to bi-directional coupler 204 of FIG. 2, detector circuits 404 and 406 may be substantially similar to respective detector circuits 210 and 212 of FIG. 2, and LP filter 410 may be substantially similar to LP filter 216 of FIG. 2.

Bi-directional coupler 402 may receive an output signal from a PA, such as PA 202 of FIG. 2, and may determine an incident signal the output, and may receive a reflection from a load, such as ARP 208 of FIG. 2, and may determine a reflected signal from the reflection. Bi- directional coupler 402 may provide the incident signal to detector circuit 404 and the reflected signal to detector circuit 406. Detector circuit 404 may determine an amplitude, A1, for the incident signal, and detector circuit 406 may determine an amplitude, A2, for the reflected signal. These amplitudes may be utilized in determining a gain of mixer circuit 408 as will be described below.

The measurement/characterization of the gain of mixer 408 may be performed by a gamma phase at the load being swept between 0 and 359 degrees. As the phase is swept between 0 and 359 degrees, a complete sinusoid may be generated at the output of LP filter 410 by measuring Vout for each gamma phase. The sinusoid at the output of LP filter 410 may be represented by V*ₒᵤₜ* = Aₘₐₓ^{∗}cos(Φ₂ - Φ₁ + Φ_{ofst}) + A_*ofst.* A Voutₘₐₓ and a Voutₘᵢₙ may be determined for the sinusoid across the phase sweep. A*_ofst* may be determined as: A_*_{ofst}* = (Voutₘₐₓ - Voutₘᵢₙ)/2. Aₘₐₓ, Φ_{ofst}, and other variables may be determined based on a FFT of the output from LP filter 410. For example, Φ_{ofst} may be equivalent to the initial phase of the sinusoid, Aₘₐₓ may be the amplitude of the fundamental, and Φ₂ - Φ₁ may be the frequency of the fundamental. Additionally, the value A₂ may be measured from the isolated detector circuit 406. Based on these calculations, the gain of mixer 408 may be substantially equal to: *mixer_{gain}* = A*max*/A₂*.* After the gain of mixer 408 has been calculated, the value of the gain may be stored in a memory of digital circuit of a PCB, such as digital circuit 220 in FIG. 1 of PCB 102 of FIG. 1.

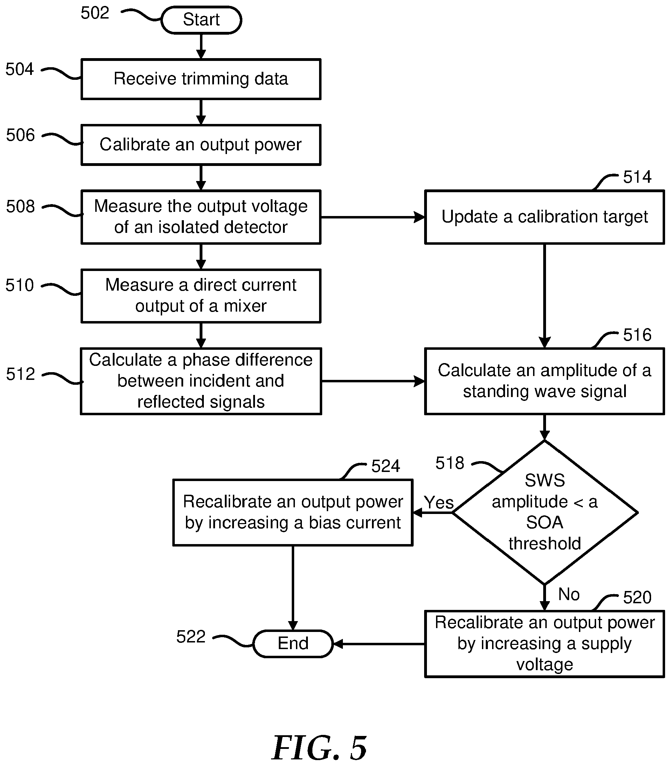

FIG. 5 illustrates a flow diagram of a method for recalibrating an output power of a power amplifier in accordance with an embodiment of the current disclosure, starting at block
502. In an example, the method may be performed by any suitable component including, but not limited to, components in circuitry 200 of FIG. 2, or any other suitable component. Not every method step set forth in this flow diagram is always necessary, and certain steps of the methods may be combined, performed simultaneously, in a different order, or perhaps omitted, without varying from the scope of the disclosure.

At block 504, trimming data for a mixer is received. The trimming data may be stored in a memory of a digital circuit of a PCB, such as digital circuit 220 in FIG. 1 of PCB 102 of FIG. 1, and the trimming data may be utilized to determine a maximum amplitude, Amax, for an output voltage. For example, the trimming data may include a gain of a mixer circuit, and Aₘₐₓ = mixer_{gain} ^{∗} A₂. In this example, A₂ is the amplitude of a reflected signal of a power amplifier, such as PA 202 of FIG. 2.

At block 506, the output voltage of the PA is calibrated. The output voltage may be calibrated in any suitable manner. For example, an amplitude of an output voltage from a coupled detector circuit may be utilized to calibrate the PA. The coupled detector circuit may determine the amplitude of an incident signal from the PA.

At block 508, an output voltage from an isolated detector circuit is measured. The output voltage from the isolated detector circuit may be an amplitude of a reflected signal in a transmission path from the PA to an antenna. The reflected signal may be created based on an impedance mismatch between the transmitter and the antenna.

At block 510, a direct current (DC) voltage of the mixer circuit is measured. At block 512, a phase difference between the incident signal and the reflected signal is determined. The phase difference may be determined or calculated in any suitable manner. For example, the phase difference may be represented by ΔΦ = acos(Vₒᵤₜ/Aₘₐₓ) - Φ_{ofst}. Amax and Φ_{ofst} may be calculated as described above with respect to FIG. 4.

At block 514, a calibration target for the PA is updated. The calibration target may be updated in any suitable manner utilizing any suitable values in transmission circuitry. The new calibration target may be determined as new calibration target = old calibration target + A₂, where A₂ is an amplitude of a reflected signal as determined by a detector circuit that is isolated from the PA. Operations in block 514 may be performed substantially parallel with the operations of blocks 510 and 512.

At block 516, an amplitude of a standing wave signal (SWS) is calculated. The amplitude of the SWS may be calculated based on the amplitude of the incident signal, the amplitude of the reflected signal, and a phase difference between the incident and reflected signals. The amplitude of the SWS may be determined as: *SWSₐₘₚ* = *incidentₐₘₚ* + *reflectedₐₘₚ* ^{∗} cos(ΔΦ).

At block 518, a determination is made whether the SWS amplitude is smaller than a SOA threshold. If the SWS amplitude is not smaller than the SOA threshold, an output power of the PA is recalibrated by increasing a supply voltage to the driver of the PA at block 520, and the flow ends are block 522. If the SWS amplitude is smaller than the SOA threshold, the output power of the PA is recalibrated by increasing a bias current to the driver of the PA at block 524, and the flow ends at block 522. In a particular embodiment, if the SWS amplitude is smaller than the SOA threshold, the output power of the PA may be recalibrated by increasing both the bias current and the supply voltage to the driver of the PA.

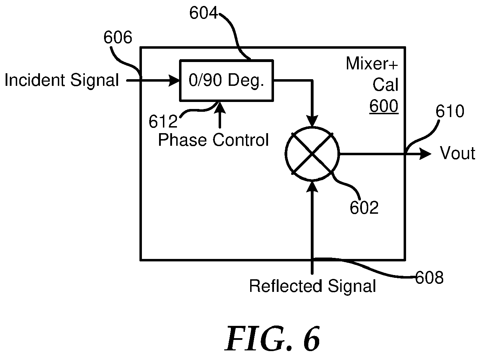

FIG. 6 illustrates mixer calibration circuitry 600 in accordance with an embodiment of the current disclosure. Mixer calibration circuitry 600 may be substantially similar to mixer circuit 214 of FIG. 2. Mixer calibration circuitry 600 includes a mixer 602, a phase control circuit 604, input terminals 606 and 608, and an output terminal 610. The incident signal, as described above with respect to FIG. 2, may be received at input terminal 606, and the reflected signal, as also described above with respect to FIG. 2, may be received at input terminal 608.
Input terminal 606 may be coupled to phase control circuit 604, which in turn is coupled to a LO input of mixer 602. Based on the incident signal being received at input terminal 606 and the LO input of mixer 602, the amplitude of the incident signal may be selected in a manner that does not affect a gain of the mixer. Mixer 602 may operate as a phase detector to determine a phase difference between the incident signal and the reflected signal.

The incident signal output from phase shift circuit 604 may be represented by V*rf*₁ = A₁^{∗}cos(wt + Φ₁) or V*rf*₁ = A₁^{∗}sin(wt + Φ₁), where A₁ is the amplitude of the incident signal measured by detector circuit 210 of FIG. 1, and Φ₁ is the phase shift of the incident signal through phase shift circuit 604. Phase shift circuit 604 includes a control input terminal 612 to receive a control signal. In certain examples, the control signal may cause phase shift circuit 604 to either not introduce a phase shift, such as 0 degree shift, or introduce a phase shift, such as a 90 degree phase shift.

The reflected signal received at input terminal 608 may be represented by V*rf*₂ = A₂^{∗}cos(wt + Φ₂), where A₂ is the amplitude of the reflected signal measured by detector circuit 212 of FIG. 1, and Φ₂ is the phase of the reflected signal. Based on the non-phase shifted incident signal and the reflected signal being received at mixer 604, the mixer may provide a first output voltage signal at output terminal 610. The first output voltage signal may be represented by V*out₀* = Aₘₐₓ^{∗}cos(Φ₂ - Φ₁ + Φ_{ofst}) + A_*ofst*, where Φ_ofst may be an offset amplitude and Φ_{ofst} may be an offset phase. Both Φ_ofst and Φ_{ofst} may be determined values, and may be independent of PVT.

Based on the phase shifted incident signal and the reflected signal being received at mixer 604, the mixer may provide a second output voltage signal at output terminal 610. The second output voltage signal may be represented by V*out₉₀* = Aₘₐₓ^{∗}sin(Φ₂ - Φ₁ + Φ_{ofst}) + A_*ofst,* where Aₘₐₓ may be calculated based upon the two voltage outputs, such as Vout₀ and Vout₉₀. Amax may be represented by Aₘₐₓ = ((Vout₀)² + (Vout₉₀)²)^{1/2}. In this equation, Aₘₐₓ may be determined without consideration of trimming data for the mixer.

Based on the equations above, Φ₂ - Φ₁ may be calculated, which is the phase of the reflected signal minus the phase of the incident signal. This difference may be referred to as the phase difference between the signals and this phase difference is utilized to correct an impedance mismatch as described above with respect to FIG. 2.

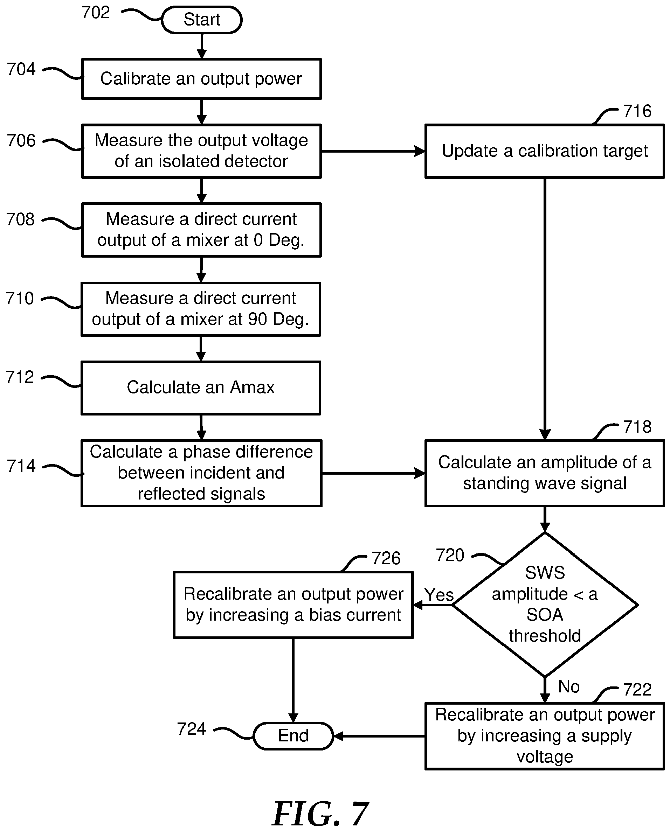

FIG. 7 illustrates a flow diagram of a method for recalibrating an output power of a power amplifier in accordance with another embodiment of the current disclosure, starting at block 702. In an example, the method may be performed by any suitable component including, but not limited to, components in circuitry 200 of FIG. 2, or any other suitable component. Not every method step set forth in this flow diagram is always necessary, and certain steps of the methods may be combined, performed simultaneously, in a different order, or perhaps omitted, without varying from the scope of the disclosure.

At block 704, the output voltage of the PA is calibrated. The output voltage may be calibrated in any suitable manner. For example, an amplitude of an output voltage from a coupled detector circuit may be utilized to calibrate the PA. The coupled detector circuit may determine the amplitude of an incident signal from the PA.

At block 706, an output voltage from an isolated detector circuit is measured. The output voltage from the isolated detector circuit may be an amplitude of a reflected signal in a transmission path from the PA to an antenna. The reflected signal may be created based on an impedance mismatch between the transmitter and the antenna.

At block 708, a direct current (DC) voltage of a mixer circuit is measured at a 0 degree phase control of an incident signal. At block 710, a direct current (DC) voltage of a mixer circuit is measured at a 90 degree phase control of an incident signal. At block 712, a maximum amplitude, Aₘₐₓ, of an output voltage from the mixer circuit is determined.

At block 714, a phase difference between the incident signal and the reflected signal is determined. The phase difference may be determined or calculated in any suitable manner. For example, the phase difference may be represented by ΔΦ = acos(Vₒᵤₜ/Aₘₐₓ) - Φ_{ofst}. Aₘₐₓ and Φ_{ofst} may be calculated as described above with respect to FIG. 4.

At block 716, a calibration target for the PA is updated. The calibration target may be updated in any suitable manner utilizing any suitable values in transmission circuitry. The new calibration target may be determined as new calibration target = old calibration target + A₂. In this example, A₂ is an amplitude of a reflected signal as determined by a detector circuit that is isolated from the PA. Operations in block 716 may be performed substantially parallel with the operations of blocks 708, 710, 712, and 714.

At block 718, an amplitude of a SWS is calculated. The amplitude of the SWS may be calculated based on the amplitude of the incident signal, the amplitude of the reflected signal, and a phase difference between the incident and reflected signals. The amplitude of the SWS may be determined as: *SWSₐₘₚ* = *incidentₐₘₚ* + *reflectedₐₘₚ* ^{∗} cos(ΔΦ).

At block 720, a determination is made whether the SWS amplitude is smaller than a SOA threshold. If the SWS amplitude is not smaller than the SOA threshold, an output power of the PA is recalibrated by increasing a supply voltage to the driver of the PA at block 722, and the flow ends are block 724. If the SWS amplitude is smaller than the SOA threshold, the output power of the PA is recalibrated by increasing a bias current to the driver of the PA at block 726, and the flow ends at block 724.

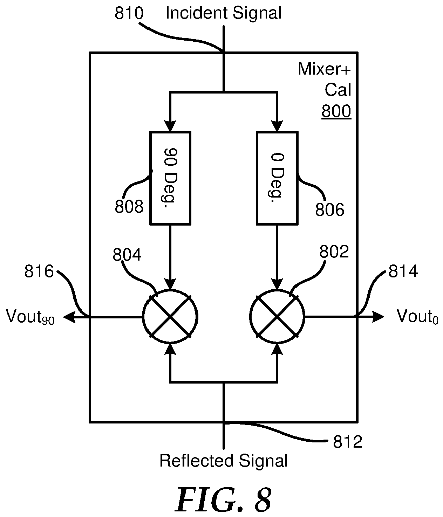

FIG. 8 illustrates mixer calibration circuitry 800 in accordance with an embodiment of the current disclosure. Mixer calibration circuitry 800 may be substantially similar to mixer circuit 214 of FIG. 2. Mixer calibration circuitry 800 includes mixers 802 and 804, phase shift
circuits 806 and 808, input terminals 810 and 812, and output terminals 814 and 806. The incident signal, as described above with respect to FIG. 2, may be received at input terminal 810, and the reflected signal, as also described above with respect to FIG. 2, may be received at input terminal 812. In certain examples, input terminal 810 may be coupled to both phase shift circuits 806 and 808. Mixers 802 and 804 may operate as phase detectors to determine a phase difference between the incident signal and the reflected signal.

The incident signal output from phase shift circuit 806 may be represented by V*rf*₁ = A₁^{∗}cos(wt + Φ₁), where A₁ is the amplitude of the incident signal measured by detector circuit 210 of FIG. 1. The incident signal output from phase shift circuit 806 may be provided to mixer 802. The incident signal output from phase shift circuit 808 may be represented by V*rf*₁ = A₁^{∗}sin(wt + Φ₁). The incident signal output from phase shift circuit 808 may be provided to mixer 804.

The reflected signal received at input terminal 812 may be represented by V*rf*₂ = A₂^{∗}cos(wt + Φ₂), where A₂ is the amplitude of the reflected signal measured by detector circuit 212 of FIG. 1, and Φ₂ is the phase of the reflected signal. The reflected signal may be provided to both mixers 802 and 804. Mixer 802 may provide an output voltage signal at output terminal 814. The output voltage signal from mixer 802 may be represented by V*out₀* = Aₘₐₓ^{∗}cos(Φ_{diff}).

Mixer 804 may provide an output voltage signal at output terminal 816. The output voltage signal may be represented by V*out₉₀* = Aₘₐₓ^{∗}sin(Φ_{diff}). Aₘₐₓ may be calculated based upon the two voltage outputs, such as V*out₀* and Vout₉₀. Amax may be represented by Aₘₐₓ = ((Vout₀)² + (Vout₉₀)²)^{1/2}. In this equation, Aₘₐₓ may be determined without consideration of trimming data for the mixer. Based on the equations above, Φ_{diff} may be calculated, which is the phase of the reflected signal minus the phase of the incident signal. This difference may be referred to as the phase difference between the signals and this phase difference is utilized to correct an impedance mismatch as described above with respect to FIG. 2.

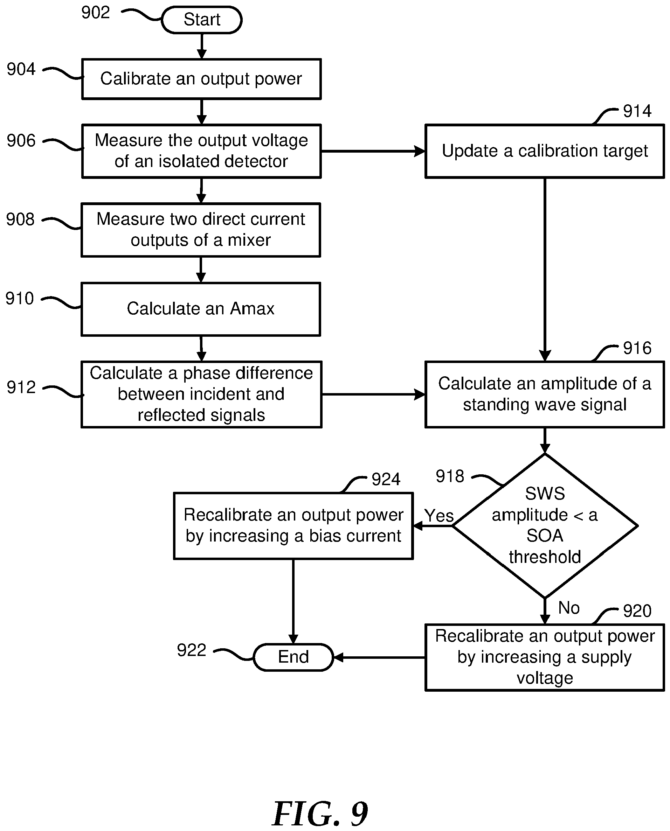

FIG. 9 illustrates a flow diagram of a method 900 for recalibrating an output power of a power amplifier in accordance with an embodiment of the current disclosure, starting at block 902. In an example, the method may be performed by any suitable component including, but not limited to, components in circuitry 200 of FIG. 2, or any other suitable component. Not every method step set forth in this flow diagram is always necessary, and certain steps of the methods may be combined, performed simultaneously, in a different order, or perhaps omitted, without varying from the scope of the disclosure.

At block 904, the output voltage of the PA is calibrated. The output voltage may be calibrated in any suitable manner. For example, an amplitude of an output voltage from a coupled detector circuit may be utilized to calibrate the PA. The coupled detector circuit may determine the amplitude of an incident signal from the PA.

At block 906, an output voltage from an isolated detector circuit is measured. The output voltage from the isolated detector circuit may be an amplitude of a reflected signal in a transmission path from the PA to an antenna. The reflected signal may be created based on an impedance mismatch between the transmitter and the antenna.

At block 908, two DC voltages of a mixer circuit is measured. The two DC voltages may be output from the mixer circuitry at substantially the same time. One of the DC voltages is measured at a 0 degree phase control of an incident signal, and the other DC voltage is measured at a 90 degree phase control of the incident signal. At block 910, a maximum amplitude, Aₘₐₓ, of an output voltage from the mixer circuit is determined.

At block 912, a phase difference between the incident signal and the reflected signal is determined. The reflected signal may be determined or calculated in any suitable manner. For example, the phase difference may be represented by ΔΦ = acos(Vₒᵤₜ/Aₘₐₓ) - Φ_{ofst}. Aₘₐₓ and Φ_{ofst} may be calculated as described above with respect to FIG. 4.

At block 914, a calibration target for the PA is updated. The calibration target may be updated in any suitable manner utilizing any suitable values in transmission circuitry. The new calibration target may be determined as new calibration target = old calibration target + A₂. In this example, A₂ is an amplitude of a reflected signal as determined by a detector circuit that is isolated from the PA. Operations in block 914 may be performed substantially parallel with the operations of blocks 908, 910, and 912.

At block 916, an amplitude of a SWS is calculated. The amplitude of the SWS may be calculated based on the amplitude of the incident signal, the amplitude of the reflected signal, and a phase difference between the incident and reflected signals. The amplitude of the SWS may be determined by: *SWSₐₘₚ* = *incidentₐₘₚ* + *reflectedₐₘₚ* ^{∗} cos(ΔΦ).

At block 918, a determination is made whether the SWS amplitude is smaller than a SOA threshold. If the SWS amplitude is not smaller than the SOA threshold, an output power of the PA is recalibrated by increasing a supply voltage to the driver of the PA at block 920, and the flow ends are block 922. If the SWS amplitude is smaller than the SOA threshold, the output power of the PA is recalibrated by increasing a bias current to the driver of the PA at block 924, and the flow ends at block 922.

Although only a few exemplary embodiments have been described in detail herein, those skilled in the art will readily appreciate that many modifications are possible in the exemplary embodiments without materially departing from the novel teachings and advantages of the embodiments of the present disclosure. Accordingly, all such modifications are intended to be included within the scope of the embodiments of the present disclosure as defined in the following claims. In the claims, means-plus-function clauses are intended to cover the structures described herein as performing the recited function and not only structural equivalents, but also equivalent structures.

The above-disclosed subject matter is to be considered illustrative, and not restrictive, and the appended claims are intended to cover any and all such modifications, enhancements, and other embodiments that fall within the scope of the present invention. Thus, to the maximum extent allowed by law, the scope of the present invention is to be determined by the broadest permissible interpretation of the following claims and their equivalents, and shall not be restricted or limited by the foregoing detailed description.

## Claims

1. A transmitter circuit, comprising:
a power amplifier to provide a transmission signal; and
a mixer calibration circuit to communicate with the power amplifier, the mixer calibration circuit to:
receive an incident signal of the transmission signal and a reflected signal of the transmission signal;
based on an amplitude of the reflected signal and on a phase difference between the incident and reflected signals, determine an amplitude of a standing wave signal; and
based on the amplitude of the standing wave signal, cause recalibration of an output voltage of the power amplifier.

2. The transmitter circuit of claim 1, further comprising:
a comparator coupled to the mixer calibration circuit, the comparator to compare the amplitude of the standing wave signal with a threshold value, and output a calibration mode signal.

3. The transmitter circuit of claim 2, further comprising:
a control circuit coupled to the comparator, the control circuit to:
receive the calibration mode signal;
in response to the calibration mode signal indicating a first calibration mode, increase a bias current to a driver of the power amplifier, wherein the increase of the bias current recalibrates the output voltage of the power amplifier; and
in response to the calibration mode signal indicating a second calibration mode, increase a supply voltage to the driver of the power amplifier, wherein the increase of the supply voltage further recalibrates the output voltage of the power amplifier.

4. The transmitter circuit of claim 3, wherein the first calibration mode is based on the amplitude of the standing wave signal being greater than the threshold value.

5. The transmitter circuit of any of claims 3 to 4, wherein the second calibration mode is based on the amplitude of the standing wave signal being less than the threshold value.

6. The transmitter circuit of any of claims 3 to 5, wherein in response to the calibration mode signal indicating the second calibration mode, the control circuit further to increase the bias current to the driver of the power amplifier.

7. The transmitter circuit of any of claims 1 to 6, wherein the mixer calibration
circuit includes: a phase control circuit to:
receive the incident signal;
based on a first phase control signal, provide the incident signal with a zero degree phase shift; and
based on a second phase control signal, provide the incident signal with a ninety degree phase shift; and
a mixer coupled to the phase control circuit, the mixer to:
receive the reflected signal;
receive the incident signal from the phase control circuit;
based on the incident signal having the zero degree phase shift, provide a first output voltage; and
based on the incident signal having the ninety degree phase shift, provide a second output voltage, wherein the amplitude of the standing wave is calculated based on the first and second output voltages and on the phase difference between the incident and reflected signals.

8. The transmitter circuit of any of claims 1 to 6, wherein the mixer calibration circuit includes: a first phase control circuit to:
receive the incident signal; and
provide the incident signal with a zero degree phase shift; a second phase control circuit to:
receive the incident signal; and
provide the incident signal with a ninety degree phase shift;
a first mixer coupled to the first phase control circuit, the first mixer
to: receive the reflected signal;
receive the incident signal with the zero degree phase shift from the first phase control circuit; and
based on the incident signal having the zero degree phase shift, provide a first output voltage; and
a second mixer coupled to the second phase control circuit, the second mixer
to: receive the reflected signal;
receive the incident signal with the ninety degree phase shift from the second phase control circuit; and
based on the incident signal having the ninety degree phase shift, provide a second output voltage, wherein the amplitude of the standing wave is calculated based on the first and second output voltages and on the phase difference between the incident and reflected signals.

9. The transmitter circuit of any of claims 1 to 8, further comprising:
a bi-directional coupler coupled to the power amplifier, the bi-directional coupler to provide the incident signal and the reflected signal to the mixer calibration circuit.

10. A method comprising:
providing, by a power amplifier of a transmitter circuit, a transmission signal;
receiving, by a mixer calibration circuit of the transmitter circuit, an incident signal of the transmission signal and a reflected signal of the transmission signal;
based on an amplitude of the reflected signal and on a phase difference between the incident and reflected signals, determining an amplitude of a standing wave signal; and
based on the amplitude of the standing wave signal, recalibrating an output voltage of the power amplifier.

11. The method of claim 10, further comprising:
comparing, by a comparator of the transmitter circuit, the amplitude of the standing wave signal with a threshold value; and
outputting, by the comparator, a calibration mode signal.

12. The method of claim 11, further comprising:
receiving, by a control circuit of the transmitter circuit, the calibration mode signal;
in response to the calibration mode signal indicating a first calibration mode, increasing, by the control circuit, a bias current to a driver of the power amplifier, wherein the increase of the bias current recalibrates the output voltage of the power amplifier; and
in response to the calibration mode signal indicating a second calibration mode, increasing, by the control circuit, a supply voltage to the driver of the power amplifier, wherein the increase of the bias current recalibrates the output voltage of the power amplifier.

13. The method of claim 12, wherein the first calibration mode is based on the amplitude of the standing wave signal being greater than the threshold value.

14. The method of any of claims 12 to 13, wherein the second calibration mode is based on the amplitude of the standing wave signal being less than the threshold value.

15. The method of any of claims 12 to 14, wherein in response to the calibration mode signal indicating the second calibration mode, the control circuit further increasing the bias current to the driver of the power amplifier.
